Europäisches Patentamt

European Patent Office

Office européen des brevets

(11) Veröffentlichungsnummer: **0 208 893**
**B1**

(12) **EUROPÄISCHE PATENTSCHRIFT**

(45) Veröffentlichungstag der Patentschrift:
20.09.89

(21) Anmeldenummer: 86107573.7

(22) Anmeldetag: 04.06.86

(51) Int. Cl.⁴: **C23C 18/18, C04B 41/53**

(54) **Vorrichtung zum Behandeln mindestens eines Keramikgegenstandes in einer Alkalihydroxidschmelze.**

(30) Priorität: 04.07.85 DE 3523961

(43) Veröffentlichungstag der Anmeldung:
21.01.87 Patentblatt 87/4

(45) Bekanntmachung des Hinweises auf die Patenterteilung:
20.09.89 Patentblatt 89/38

(84) Benannte Vertragsstaaten:
AT BE CH DE FR GB IT LI LU NL SE

(56) Entgegenhaltungen:
EP-A- 0 128 476
CH-A- 213 296
FR-A- 2 116 376
FR-A- 2 233 154

(73) Patentinhaber: Licentia Patent-Verwaltungs-GmbH,
Theodor-Stern-Kai 1, D-6000 Frankfurt/Main 70(DE)

(72) Erfinder: Bogenschütz, August-Friedrich, Prof. Dr. rer.
nat., Beethovenstrasse 10, D-7931 Oberdischingen(DE)
Erfinder: Jostan, Josef L., Dr. rer. nat., Haslacherweg 21,
D-7900 Ulm(DE)
Erfinder: Ostwald, Robert, Dr.-Ing., Hasensteige 8,
D-7900 Ulm(DE)

(74) Vertreter: Schulze, Harald Rudolf, Dipl.-Ing. et al,
Licentia Patent-Verwaltungs-GmbH
Theodor-Stern-Kai 1, D-6000 Frankfurt/Main 70(DE)

## Beschreibung

Vorrichtung zum Behandeln mindestens eines Keramikgegenstandes in einer Alkalihydroxidschmelze

Die Erfindung betrifft eine Vorrichtung zum Behandeln eines Keramikgegenstandes in einer Alkalihydroxidschmelze nach dem Oberbegriff des Patentanspruchs 1. Die Erfindung betrifft insbesondere eine Vorrichtung zur Behandlung von Keramikplatten, die durch nachfolgende Metallisierung zu elektrischen Schaltungen weiterverarbeitet werden.

Gegenstände aus Keramik werden metallisiert, um deren funktionelle Eigenschaften zu verändern, zu verbessern oder zu vermehren, wie zum Beispiel die elektrische oder die Wärmeleitfähigkeit, die Korrosionsbeständigkeit, die Verschleißfestigkeit oder auch die dekorativen Eigenschaften. Bei derartigen Metallisierungen ist die Haftfestig keit der Metallauflage zur Keramik von besonderer Bedeutung. Die Haftung der Schichten kommt, stark verallgemeinert, entweder durch relativ schwache Wechselwirkungen zwischen Schicht- und Unterlagematerial (sog. 'Van der Waals-Kräfte'), oder durch chemische Bindungen oder auch durch mechanische Verankerungen oder durch eine Kombination dieser Beiträge zustande. Die Anteile dieser einzelnen Beiträge hängen vorwiegend von der Art der Vorbehandlung der Keramiksubstrate ab. So kann zum Beispiel der Anteil der mechanischen Verankerung durch aufrauhende Vorbehandlung erhöht werden.

An Keramikoberflächen muß in der Regel vor allem die sogenannte glasartige Brennhaut, welche die meisten Keramiksorten chemisch inert macht, reproduzierbar entfernt werden. Dafür muß ein geeignetes Verfahren angewandt werden, welches die Keramikoberflächen nicht nur reinigt, sondern vielmehr durch einen Abtragungsprozeß chemischer Art aktiviert, damit chemische Bindungen zu den Oberflächen freigelegter Keramikkristallite erfolgen können. Diser Abtragungsprozeß darf die Oberflächen aber weder zu stark aufrauhen noch das Materialgefüge lockern, da anderenfalls mechanische Verankerungen zu leicht ausbrechen. Ein chemischer Ätzprozeß, durch den primär die glasartige Brennhaut entfernt wird, ist daher am geeignetsten. Für das in der Elektronik am meisten angewandte Keramik-Substratmaterial aus Aluminiumoxid werden in der Literatur (R.Bock: Aufschlußmethoden der anorganischen und organischen Chemie, Verlag Chemie, Weinheim/Bergstraße, 1972) eine Reihe von Ätzmitteln vorgeschlagen, so zum Beispiel Phosphor-, Schwefel-, Salpeter- und Flußsäure oder Ammoniumhydrogenfluorid sowie auch Natronlauge oder eine Natriumhydroxid-Schmelze. Die Säuren erweisen sich aber in der Regel als zu wenig wirksam, während die Alkalien erst bei sehr hoher Temperatur, dann aber zu stark oder ungleichmäßig die Keramikoberflächen angreifen. Wird das Verfahren der Tauchbeschichtung mit Natronlauge angewandt, so muß die Schicht erst eingetrocknet werden, wobei in nachteiliger Weise die Gefahr der Karbonatisierung besteht, und dann bei sehr hoher Temperatur (ungefähr 500 °C) gebrannt werden, wobei die geringen Alkalihydroxidmengen sich ungleichmäßig verteilen und schnell mit der Unterlage abreagieren, so daß kein weiterer Ätzangriff erfolgen kann.

Auch bei dem Verfahren der Tauchbehandlung in einer Schmelze eines Alkalihydroxids kann selbst über dem Schmelzpunkt von beispielsweise 318 °C bei Natriumhydroxid kein wesentlich stärkerer Ätzangriff erfolgen. Ein schwerwiegender Nachteil dieses Verfahrens ist außerdem die schwierige Handhabung dieser äußerst aggressiven Schmelzen, die praktisch alle üblichen Gerätematerialien stark angreifen, sowie deren leichte Karbonatisierung durch Aufnahme von Kohlendioxid aus der Umgebungsluft, wodurch die Ätzbedingungen nachteilig verändert werden.

Die Aufgabe der Erfindung besteht darin, eine gattungsgemäße Vorrichtung dahingehend zu verbessern, daß eine sichere Handhabung der Schmelze und eine reproduzierbare sowie ausreichend starke Anätzung von Keramikoberflächen ermöglicht wird, inbesondere bei einer industriellen Massenfertigung.

Die Aufgabe wird durch die im kennzeichnenden Teil des Patentanspruchs 1 angegebenen Merkmale gelöst. Zweckmäßige Ausgestaltungen und/oder Weiterbildungen sind den Unteransprüchen zu entnehmen.

Die Erfindung wird im folgenden anhand eines Ausführungsbeispiels näher erläutert unter Bezugnahme auf eine schematische Zeichnung. Es zeigen

FIG. 1 ein Diagramm zur Erläuterung der Funktionsweise des in
FIG. 2 dargestellten Ausführungsbeispiels.

Die Erfindung beruht darauf, daß die Vorrichtung aus einem ätzalkaliresistenten Material, zum Beispiel Kohlenstoffarmem Nickel und/oder vergoldetem Stahl, aufgebaut ist, daß sich über der Alkalihydroxidschmelze eine kohlendioxidfreie Gasatmosphäre befindet, daß diese Atmosphäre beheizt wird und somit Keramikgegenstände in dieser Atmosphäre vorgewärmt werden und daß diese Atmosphäre eine bestimmte Menge an Wasserdampf enthält und über den Wasserdampfpartialdruck die Alkalihydroxidschmelze einen im thermodynamischen Gleichgewicht vorbestimmten konstanten Wassergehalt hat. Der Wassergehalt einer beispielhaften Natriumhydroxidschmelze hat einen ganz entscheidenden Einfluß auf die Gleichmäßigkeit und den Grad der Anätzung und/oder Aufrauhung der Keramikoberfläche und somit die haftfeste Verankerung einer darauf erzeugten Metallisierung.

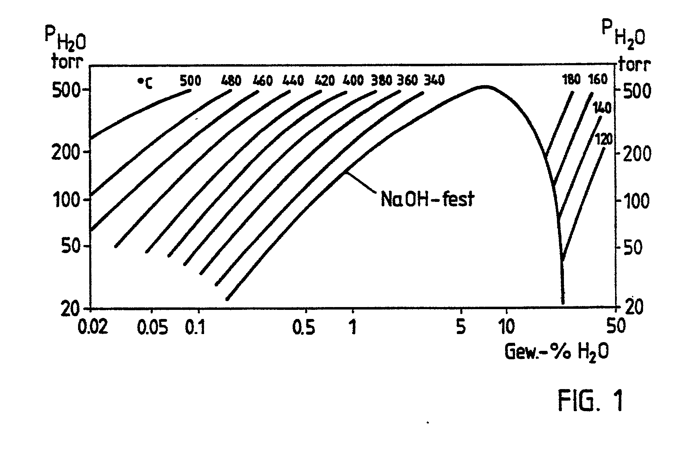

FIG. 1 zeigt den Wassergehalt, gemessen in Gewichtsprozent (Gew. -%), von festem oder flüssigem NaOH in Abhängigkeit von einem über dem NaOH vorhandenen Wasserdampfpartialdruck $P_{H_2O}$, gemessen in Torr. Bei der dargestellten Kurvenschar ist als Scharparameter die Temperatur, gemessen in °C, angegeben. Es ist also möglich, für einen vorgebbaren $H_2O$-Gehalt einer NaOH-Schmelze, den darüber befindlichen Wasserdampfpartialdruck derart zu steuern und/oder zu regeln, daß der $H_2O$-Gehalt in der alkalihydroxidschmelze erhalten bleibt.

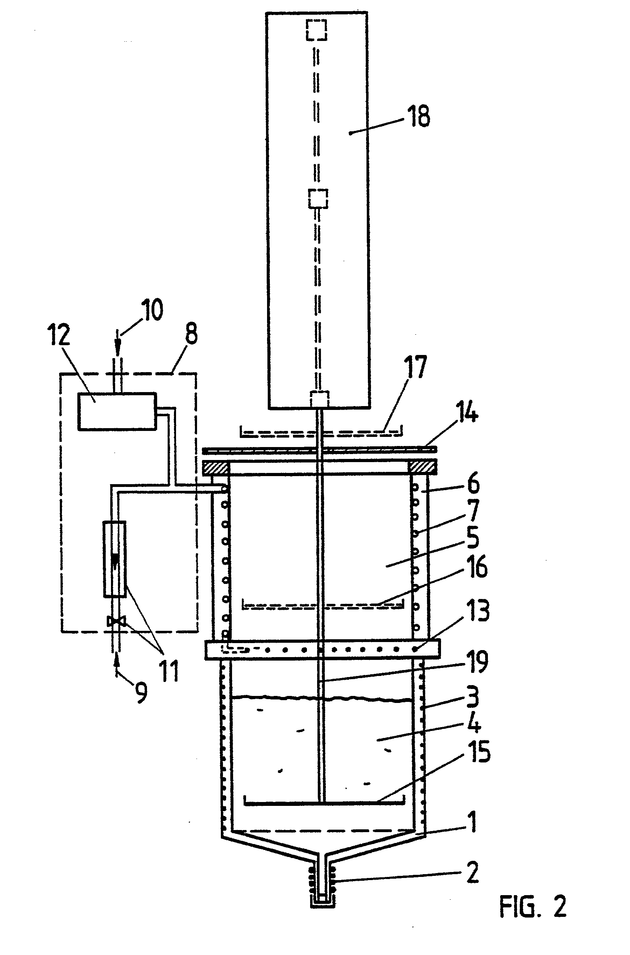

In dem Ausführungsbeispiel gemäß FIG. 2 ist ein Schmelztiegel 1 vorhanden, der von einer elektrischen Tiegelheizung 3 umgeben ist und der an seinem Boden einen heiz- sowie verschließbaren Ablauf 2 besitzt. In dem Schmelztiegel 1 ist eine Alkalihydroxidschmelze 4 vorhanden, zum Beispiel eine NaOH-Schmelze, die auf einer Temperatur von ungefähr 325 °C gehalten wird. Oberhalb des Schmelztiegels 1 ist eine mit diesem im wesentlichen gasdicht verbundene Vorwärmkammer 5 vorhanden, deren heizbares Gehäuse 6 eine durch elektrischen Strom direkt heizbare Rohrspirale 7 enthält. Das obere Ende der Rohrspirale 7 ist mit einer Gas- und/oder Dampfmischanordnung 8 gekoppelt, der ein inertes Gas 9, zum Beispiel Stickstoff, sowie demineralisiertes Wasser 10 zugeführt wird. Das inerte Gas 9 durchläuft eine Steuer- und/oder Regeleinrichtung 11, in der ein im wesentlichen konstanter Gasstrom erzeugt wird. Diesem wird über eine Dosierpumpe 12 eine genau einstellbare Wassermenge zugesetzt. Es entsteht ein Gas- Wasserdampfgemisch, das in der Rohrspirale 7 aufgeheizt wird und über eine Düsenanordnung 13 auf die Oberfläche der Alkalihydroxidschmelze 4 geleitet wird. Dadurch wird erreicht, das über der Alkalihydroxidschmelze 4 immer der erforderliche Wasserdampfpartialdruck vorhanden ist und daß eine Karbonatisierung vermieden wird. Die Vorwärmkammer 5 ist abgedeckt durch einen Deckel 14.

Die Zuordnung Wassergehalt der Schmelze/Partialdruck des Wasserdampfes über der Schmelze wird durch eine Versuchsreihe ermittelt. Dazu werden unterschiedliche Wassergehalte in einer Natriumhydroxidschmelze bei einer konstanten Temperatur von 325 °C eingestellt, indem die in folgender Tabelle angegebenen Stickstoffraten und Wasserdosierungen einreguliert werden.

| $N_2$ ($R_1$) (N l/h) | $H_2O_{fl}$ (m l/h) | $H_2O_{gas}$ ($R_2$) (N l/h) | $P(H_2O)$ (Torr) | $H_2O$-Gehalt der Schmelze (nach Fig. 1) (Gew.-%) |
|---|---|---|---|---|
| 600 | 0 | 0 | 0 | 0 |
| 600 | 24 | 30 | 34 | 0,2 |
| 600 | 48 | 60 | 65 | 0,4 |
| 600 | 96 | 120 | 120 | 0,7 |
| 600 | 240 | 299 | 240 | 1,4 |
| 600 | 480 | 598 | 359 | 2,9 |
| 600 | 960 | 1196 | 479 | 4,9 |

Die Wasserdampfpartialdrucke

$$P_{H_2O} = \frac{R_2}{R_1 + R_2} \, P$$

werden mit Hilfe der Gas-Raten von Stickstoff ($R_1$) und Wasserdampf ($R_2$) bei einem Gesamtdruck p von 720 Torr (bei ungefähr 500 m üNN) berechnet. Bei diesen Atmosphären wird die Schmelze 7 Stunden lang belassen nur durch gelegentliches Rühren unterbrochen. Innerhalb dieser Zeit ist dann die Gleichgewichtseinstellung erfolgt.

In die derart aufbereitete Alkalihydroxidschmelze 4 werden nun die zu behandelnden Keramikkörper, zum Beispiel Keramikplatten aus $Al_2O_3$ mit einer Dicke von ungefähr 1mm, eingebracht mit Hilfe einer Halterung 15, zum Beispiel einer Lochplatte aus reinem Nickel. Die Halterung 15 ist außer in der dargestellten Lage in der Alkalihydroxidschmelze 4 noch in einer Vorwärmposition 16 in der Vorwärmkammer 5 sowie einer Abkühlposition 17 oberhalb der Vorwärmkammer 5 feststellbar.

Dieses wird erreicht durch eine motorisch angetriebene Eintauch- und Ausziehvorrichtung 18, die über ein Gestänge 19 mit der Halterung 15 gekoppelt ist.

Die Halterung 15 wird damit zunächst bei geschlossenem Deckel 14 in die Abkühlposition 17 gebracht und mit den zu behandelnden Keramikkörpern bestückt. Anschließend wird der Deckel 14 selbsttätig geöffnet, die Halterung 15 bis in die Vorwärmposition 16 abgesenkt (der Deckel wird automatisch geschlossen) und dort belassen für eine Vorwärmzeit, die ungefähr 20 min beträgt. Anschließend wird die Halterung 15 weiter abgesenkt bis in die Alkalihydroxidschmelze 4, so daß die Keramikkörper dort angeätzt werden, zum Beispiel während einer Ätzzeit von ungefähr 10 min. Anschließend wird die Halterung 15 wieder in die Vorwärmposition 16 gezogen, der Deckel 14 geöffnet, die Halterung 15 in die Abkühlposition 17

3

gebracht und der Deckel 14 wieder geschlossen. Nach dem Abkühlen werden die Keramikkörper entfernt und in weiteren Verfahrensschritten metallisiert.

Bei der beschriebenen Vorrichtung sind zumindest alle mit der Alkalihydroxidschmelze 4 in Berührung kommenden Teile, zum Beispiel der Schmelztiegel 1 sowie die Halterung 15, aus einem ätzalkalibeständigem Material hergestellt, zum Beispiel aus Rein-Nickel LC mit einem Kohlenstoffgehalt von weniger als 0,02% oder aus einem CrNi-Stahl, der dickvergoldet ist.

Die beschriebene Vorrichtung ist in vorteilhafter Weise derart steuer- und/oder regelbar, daß die Keramikkörper in kostengünstiger sowie reproduzierbarer Weise immer nach dem gleichen Verfahrensschema behandelt werden, so daß eine genau vorherbestimmbare angeätzte Oberfläche entsteht, die eine sehr haftfeste Metallisierung ermöglicht.

Die Erfindung ist nicht auf das beschriebene Ausführungsbeispiel beschränkt, sondern sinngemäß auf weitere anwendbar. Beispielsweise ist es möglich als Alkalihydroxidschmelze ein eutektisches Alkalihydroxid-Gemisch zu verwenden, das zum Beispiel aus 41 Gew.% NaOH und 59 Gew.% KOH besteht. Ein derartiges Gemisch ist beispielsweise anwendbar für Keramikkörper aus Porzellan.

**Patentansprüche**

1. Vorrichtung zum Behandeln mindestens eines Keramikgegenstandes in einer Alkalihydroxidschmelze, bestehend aus einem heizbaren Schmelztiegel (1), welcher die Alkalihydroxidschmelze (4) enthält und welcher eine Öffnung besitzt, durch welche der Keramikgegenstand bis in die Alkalihydroxidschmelze (4) eingetaucht wird,
– bei welcher der Schmelztiegel (1) im wesentlichen senkrecht angeordnet ist und an seinem Boden einen verschließbaren Ablauf (2) besitzt,
– bei welcher oberhalb des Schmelztiegels (1) eine Vorwärmkammer (5) vorhanden ist, deren heizbares Gehäuse (6) einerseits im wesentlichen gasdicht mit dem Schmelztiegel (1) verbunden ist und andererseits an seinem oberen Ende eine verschließbare Öffnung besitzt, durch welche eine Halterung (15) zuführbar ist, auf welcher die Keramikgegenstände gehalten werden,
– bei welcher oberhalb der Alkalihydroxidschmelze (4) eine Düsenanordnung (13) vorhanden ist, durch welche der Oberfläche der Alkalihydroxidschmelze (4) ein Gas- und/oder Dampfgemisch zuführbar ist, dadurch gekennzeichnet,
– daß die Halterung (15) mit einer steuer- und/oder regelbaren Eintauch- sowie Ausziehvorrichtung (18) verbunden ist, die ein Anhalten der Halterung außerhalb oder innerhalb der Vorwärmkammer (5) oder innerhalb der Alkalihydroxidschmelze ermöglicht.

2. Vorrichtung nach Anspruch 1, dadurch gekennzeichnet, daß der Ablauf (2) heizbar ist.

3. Vorrichtung nach Anspruch 1 oder Anspruch 2, dadurch gekennzeichnet, daß das Gehäuse (6) der Vorwärmkammer eine Rohrspirale (7) enthält, deren eines Ende mit der Düsenanordnung (13) verbunden ist, an derem anderen Ende eine Gas- und/oder Dampfmischanordnung (8) angekoppelt ist und die als elektrische Widerstandsheizung ausgebildet ist.

4. Vorrichtung nach einem der vorhergegangenen Ansprüche, dadurch gekennzeichnet, daß in der Gas- und/oder Dampfmischanordnung (8) im wesentlichen ein Gemisch aus einem inerten Gas, vorzugsweise Stickstoff, mit Wasserdampf erzeugt wird, das in der Rohrspirale (7) erhitzt wird und durch die Düsenanordnung (13) über die Alkalihydroxidschmelze (4) geleitet wird.

5. Vorrichtung nach einem der vorhergegangenen Ansprüche, dadurch gekennzeichnet, daß die Gas- und/oder Dampfmischanordnung (8) eine Steuer- und/oder Regeleinrichtung (11) enthält zur Steuerung und/oder Regelung des Durchflusses des inerten Gases sowie eine Dosierpumpe (12) zur Dosierung von Wasser, das mit dem inerten Gas vermischt wird durch Einspritzen und Verdampfen an dem geheizten Ende der Rohrspirale (7), und daß durch das Verhältnis von eingespritzter Wassermenge zum Gasdurchsatz des inerten Gases ein vorherbestimmbarer Wasserdampfpartialdruck über der Alkalihydroxidschmelze (4) einstellbar ist.

6. Vorrichtung nach einem der vorhergehenden Ansprüche, dadurch gekennzeichnet, daß die Gas- und/oder Dampfmischanordnung (8) derart einstellbar ist, daß über der Alkalihydroxidschmelze (4) ein Gas- und/oder Dampfgemisch entsteht, welches den Zutritt von Kohlendioxid vermeidet und welches einen in die Vorwärmkammer (5) eingebrachten Keramikgegenstand erwärmt.

7. Vorrichtung nach einem der vorhergegangenen Ansprüche, dadurch gekennzeichnet, daß die Eintauch- sowie Ausziehvorrichtung (18) motorisch steuer- und/oder regelbar ausgebildet ist zum definierten Behandeln des Keramikgegenstandes.

8. Vorrichtung nach einem der vorhergegangenen Ansprüche, dadurch gekennzeichnet, daß die Vorwärmkammer (5) eine verschließbare Öffnung besitzt, deren zugehöriger Deckel (14) in Abhängigkeit von der Lage der Halterung (15) bewegt wird.

9. Vorrichtung nach einem der vorhergegangenen Ansprüche, dadurch gekennzeichnet, daß zumindest der Schmelztiegel (1) aus einem ätzalkalibeständigem Material besteht, das gegenüber einen wasserhaltigen NaOH–Schmelze und/oder einem wasserhaltigen eutektischen KOH- und NaOH-Gemisch beständig ist.

## Revendications

1. Dispositif pour le traitement d'au moins un objet en céramique dans un bain d'hydroxydes alcalins fondus, consistant en un creuset chauffant (1) contenant le bain d'hydroxydes alcalins fondus (4) et possédant, une ouverture à travers laquelle l'objet en céramique est immergé jusque dans le bain d'hydroxydes alcalins fondus (4),
   dans lequel le creuset (1) est essentiellement disposé verticalement et comporte au fond un tuyau de vidange (2) obturable,
   dans lequel une chambre de préchauffage (5) se trouve au-dessus du creuset (1) dont l'enveloppe chauffante (6) communique d'une part avec le creuset (1) tout en étant pratiquement étanche aux gaz et comporte d'autre part à son extrémité supérieure une ouverture obturable
   dans laquelle peut s'engager un support de fixation (15) sur lequel sont maintenus les objets en céramique,
   dans lequel un dispositif à buses (13) est placé au-dessus du bain d'hydroxydes alcalins fondus (4), par lequel un mélange de gaz et/ou de vapeur peut être amené à la surface du bain d'hydroxydes alcalins fondus (4), caractérisé en ce que le support de fixation (15) est raccordé à un dispositif d'immersion et/ou d'extraction (18) pouvant être commandé et/ou réglé, qui permet le blocage du support de fixation en dehors ou à l'intérieur de la chambre de préchauffage (5) ou à l'intérieur du bain d'hydroxydes alcalins fondus.

2. Appareil selon la revendication 1, caractérisé en ce que le tuyau de vidange (2) peut être chauffé.

3. Appareil selon la revendication 1 ou 2, caractérisé en ce que l'enveloppe (6) de la chambre de préchauffage comporte une spirale tubulaire (7) dont une extrémité est reliée au dispositif à buses (13) et à l'autre extrémité de laquelle est raccordée un dispositif de mélange de gaz et/ou de vapeur (8) et qui est conçue sous forme de chauffage par résistance électrique.

4. Appareil selon l'une des revendications précédentes, caractérisé en ce que, dans le dispositif de mélange de gaz et/ou de vapeur (8), il est essentiellement produit un mélange d'un gaz inerte, de préférence de l'azote, avec de la vapeur d'eau qui est chauffé dans la spirale tubulaire (7) et dirigé sur le bain d'hydroxydes alcalins fondus (4) à travers le dispositif à buses (13).

5. Appareil selon l'une des revendications précédentes, caractérisé en ce que le dispositif de mélange de gaz et/ou de vapeur (8) comporte un dispositif de commande et/ou de réglage (11) pour la commande et/ou le réglage du débit de gaz inerte ainsi qu'une pompe doseuse (12) pour l'introduction dosée d'eau qui est mélangée au gaz inerte par injection et vaporisation à l'extrémité chauffée de la spirale tubulaire (7) et que, grâce au rapport de la quantité d'eau injectée au débit de gaz inerte, une pression partielle de vapeur d'eau déterminable à l'avance peut être réglée au-dessus du bain d'hydroxydes alcalins fondus (4).

6. Appareil selon l'une des revendications précédentes, caractérisé en ce que le dispositif de mélange de gaz et/ou de vapeur (8) peut être réglé de telle façon qu'il se forme au-dessus du bain d'hydroxydes alcalins fondus (4) un mélange de gaz et/ou de vapeur qui empêche l'accès de l'anhydride carbonique et chauffe un objet en céramique introduit dans la chambre de préchauffage (5).

7. Appareil selon l'une des revendications précédentes, caractérisé en ce que le dispositif d'immersion et d'extraction (18) est conçu de manière à pouvoir être commandé et/ou réglé par moteur en vue du traitement défini de l'objet en céramique.

8. Appareil selon l'une des revendications précédentes, caractérisé en ce que la chambre de préchauffage (5) possède une ouverture obturable dont le couvercle correspondant (14) est déplacé en fonction de la position du support de fixation (15).

9. Appareil selon l'une des revendications précédentes, caractérisé en ce qu'au moins le creuset (1) est constitué par un matériau résistant aux alcalis caustiques qui résiste à un bain de NaOH fondu contenant de l'eau et/ou à un mélange eutectique de KOH et NaOH contenant de l'eau.

## Claims

1. Device, for the treatment of at least one ceramic object in a molten alkali hydroxide bath, consisting of a heatable melting crucible (1), which contains the molten alkali hydroxide bath (4) and possesses an opening, through which the ceramic object is dipped into the molten alkali hydroxide bath (4),
   — in which the melting crucible (4) is arranged substantially vertically and possesses a closable outlet (2) at its base,
   — in which a preheating chamber (5), the heatable housing (6) of which on the one hand is connected with the melting crucible (4) in substantially gas-tight manner and on the other hand at its upper end possesses a closable opening, through which a mount (15) is feedable, on which the ceramic objects are retained, is present above the melting crucible (4),
   — in which a nozzle arrangement (13), through which a gas and/or vapour mixture is feedable to the surface of the molten alkali hydroxide bath (4), is present above the molten alkali hydroxide bath (4), characterised thereby, that
   — the mount (15) is connected with a controllable and/or regulable immersion as well as withdrawal device (18), which makes a stopping of the mount possible outside or inside the preheating chamber (5) or inside the molten alkali hydroxide bath.

2. Device according to claim 1, characterised thereby, that the outlet (2) is heatable.

3. Device according to claim 1 or claim 2, characterised thereby, that the housing (6) of the preheating chamber contains a tube coil (7), the one end of which is connected with the nozzle arrangement (13) and the other end of which is coupled with a gas and/or vapour mixing arrangement (8) and which is constructed as electrical resistance heater.

4. Device according to one of the preceding claims, characterised thereby, that substantially a mixture of an inert gas, preferably nitrogen, with water vapour is produced in the gas and/or vapour mixing arrangement (8), is heated in the tube coil (7) and led over the molten alkali hydroxide bath (4) through the nozzle arrangement (13).

5. Device according to one of the preceding claims, characterised thereby, that the gas and/or vapour mixing arrangement (8), contains a control and/or regulating equipment (11) for the control and/or regulation of the throughflow of the inert gas as well as a metering pump (12) for the metering of water which is intermixed with the inert gas through injection and evaporation at the heated end of the tube coil (7), and that a predeterminable water vapour partial pressure above the molten alkali hydroxide bath (4) is adjustable through the ratio of injected quantity of water to the gas throughput of the inert gas.

6. Device according to one of the preceding claims, characterised thereby, that the gas and/or vapour mixing arrangement (8) is adjustable in such a manner that a gas and/or vapour mixture, which avoids the access of carbon dioxide and heats a ceramic object introduced into the preheating chamber (5), arises above the molten alkali hydroxide bath (4).

7. Device according to one of the preceding claims, characterised thereby, that the immersion as well as withdrawal device (18) is constructed to be controllable and/or regulable through a motor drive for the defined treatment of the ceramic object.

8. Device according to one of the preceding claims, characterised thereby, that the preheating chamber (5) possesses a closable opening, the lid (14) belonging to which is moved in dependence on the position of the mount (15).

9. Device according to one of the preceding claims, characterised thereby, that at least the melting crucible (4) consists of a material which is resistant to caustic alkalis, a NaOH melt containing water and/or an eutectic mixture, containing water, of KOH and NaOH.

FIG. 1

EP 0 208 893 B1

FIG. 2